(19) **Europäisches Patentamt / European Patent Office / Office européen des brevets**

(11) **EP 1 513 252 B1**

(12) **EUROPEAN PATENT SPECIFICATION**

(45) Date of publication and mention
of the grant of the patent:
**01.12.2010 Bulletin 2010/48**

(51) Int Cl.:
**H03G 7/00** *(2006.01)* **H03G 7/06** *(2006.01)*

(21) Application number: **03425568.7**

(22) Date of filing: **02.09.2003**

(54) **Logarithmic linear variable gain CMOS amplifier**

Logarithmischer linearer CMOS-Verstärker mit variabler Verstärkung

Amplificateur CMOS logarithmique linéaire à gain variable

(84) Designated Contracting States:
**DE FR GB IT**

(43) Date of publication of application:
**09.03.2005 Bulletin 2005/10**

(73) Proprietor: **STMicroelectronics Srl**
**20041 Agrate Brianza (MB) (IT)**

(72) Inventors:
• **Gaeta, Marco**
**26866 Sant'Angelo Lodigiano (IT)**

• **Bollati, Giacomino**
**29015 Castel San Giovanni (IT)**
• **Bongiorni, Marco**
**29015 Castel San Giovanni (IT)**

(74) Representative: **Pellegri, Alberto et al**
**Società Italiana Brevetti S.p.A.**
**Via Avegno, 6**
**21100 Varese (IT)**

(56) References cited:
**EP-A- 1 024 450**   **US-A- 5 886 579**
**US-A1- 2002 048 109**   **US-B1- 6 584 486**

**Description**

The present invention relates in general to integrated analog circuits and more in particular to an integrated logarithmic linear variable gain CMOS amplifier.

State of the art logarithmic linear amplifiers are based on a circuit structure as that depicted in Figure 1. Such a structure is disclosed in the published patent application No. US 2002/0048109 A1.

The gain of these amplifiers commonly employing two stages for increasing the gain range is given by an expression of the form:

$$Gain = \sqrt{\frac{1+x}{1-x}} \qquad\qquad (1)$$

The linear logarithmic gain (dB gain) variation range of the function is relatively restricted. Generally the value of x of the gain expression for remaining in substantially linear dB gain variation range is limited to $-0.7 < x < 0.7$.

The variation of the bias current in a transistor notably alters its transconductance thus obtaining the desired behaviour of the circuit according to equation 1, but the variation of the bias current affects also the bandwith and the linearity of the amplifier.

The group delay of the amplifier circuit is (inversely) proportional to the bandwidth.

On the other hand it would be strongly desirable to render the group delay independent from the gain to prevent interaction between gain loop and phase loop.

Variable gain amplifiers work with fixed output voltage swing (fixed by the control loop) and the gain is inversely proportional to the input voltage swing.

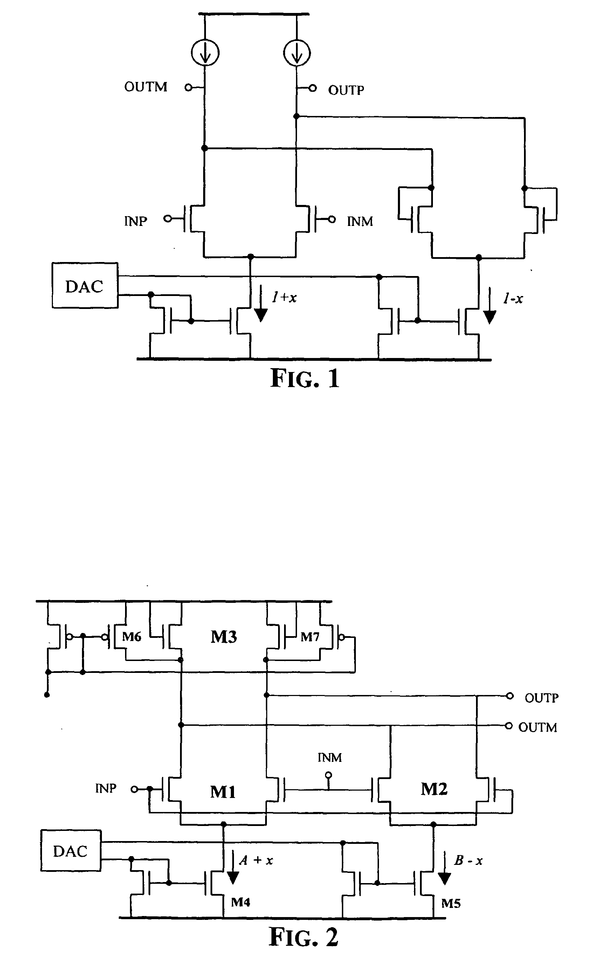

While it would be highly desirable that linearity should be inversely proportional to the gain, the known amplifier structures such as the one depicted in Figure 1 unfortunately have the opposite behaviour.

Therefore, there is a clear need and/or usefulness of a logarithmic linear variable gain amplifier wherein the group delay is rendered substantially independent from the gain and the linearity of the amplifier made to be inversely proportional to the gain.

The document EP 1 024 450 discloses an analog Gilbert multiplier circuit that includes two differential pairs of bipolar transistors, arranged for realizing a "boxplus" OR function, defined as the inverse hyperbolic tangent of the product of two hyperbolic tangent functions.

The US patent No. 6,584,486 discloses a method for mathematically processing in a combination circuit at least two values represented in differential form, either as a pair of voltages or as a pair of currents.

It has been found that the above-identified objectives may be obtained in a relatively simple manner, without substantially adding complexity to the basic circuit of an integrated logarithmic linear variable gain amplifier, by cross connecting two differential pairs of transistors that share the same diode loads and by biasing the two differential pairs of transistors so connected with currents such that their sum remains constant. In practice this is achieved by mirroring in the common current node of the two differential pairs of transistors the required bias currents provided by the linear dac and which have value A + x and B - x, respectively, where A and B are the respective bias current and $x$ is the variable factor.

In this way the sum of the two currents is kept constant and so is the bandwith that depends on it.

The invention is defined in claim 1.

According to an optional but highly preferred embodiment, the diode loads, common to the two cross connected differential input stages have transistor means connected in parallel to the diode loads for subtrackting a constant current of a desired value from the current that would otherwise be flowing through the diode loads. This permits to translate the gain curve of the amplifier according to needs.

**Figure 1** represents, as already noted above, the basic circuit of a state of the art integrated logarithmic linear variable gain CMOS amplifier.

**Figure 2** shows the circuit diagram of a logarithmic linear variable gain CMOS amplifier according to a preferred embodiment of this invention.

**Figure 3** is a diagram of the gain characteristics of an amplifier according to the present invetion.

As depicted in Figure 2, the two differential transistor pairs, M1 and M2, sharing the same diode-connected load transistors M3, are cross connected to the input nodes INP and INM of the amplifier, according to an essential feature of the novel circuit of this invention.

Being $gm_1$ the transconductance of the first input differential pair of transistors M1, $gm_2$ the transconductance of the second input differential pair of transistors M2, and $gm_3$ the transconductance of the diode-connected load transistors M3 , it may be demonstrated that the gain is given by the following equation:

$$Gain = \frac{gm_1 - gm_2}{gm_3} = \frac{\sqrt{K_1 \cdot I_1} - \sqrt{K_2 \cdot I_2}}{\sqrt{K_3 \cdot I_3}} \qquad (2)$$

where $K_i$ is the transistor's gain constant proportional its "aspect ratio" W/L, $I_1$, $I_2$ and $I_3$ are the bias currents of M1, M2 and M3 respectively, and the bandwith is given by the following equation:

$$Bandwidth \cong \frac{\sqrt{K_3 \cdot I_3}}{\pi \cdot C_{out}} \qquad (3)$$

wherein $C_{out}$ is the capacitance of the output node, referred to the virtual ground node of the circuit.

Customarily, the two differential pairs of transistors M1 and M2 are biased by respective currents output by a linear digital-to-analog converter through respective current mirrors M4 and M5, and the pair M3 of diode connected load transistors is biased by the difference between the sum of these currents and the currents flowing in M6 and M7.

According to an essential condition of this invention, the two bias currents have a value given by expressions of the type: A + x and B - x, where A and B are the pre-established bias current values while x represents the variable factor. Therefore, the sum of the two bias currents is kept constant such that $I_3 = I_1 + I_2$.

In the case of the preferred embodiment depicted in Figure 2, wherein transistor means M6 and M7 are included for subtracting a constant amount of the current that would otherwise be flowing in the two diode-connected load transistors M3, the sum current $I_{TOT}$ will be equal to the actual bias current $I_3$ plus the constant amount that is subtracted by flowing through the optionally added transistors M6 and M7. In any case the effective bias current $I_3$ of the bandwidth equation 3 will be constant, ensuring constancy of the bandwidth.

Accordingly, the gain in dB is given by the following expression:

$$\left(\frac{v_{out}}{v_{in}}\right)_{dB} = 20 \cdot \log\left(\sqrt{K_1 \cdot Id_1} - \sqrt{K_2 \cdot Id_2}\right) - 10 \cdot \log(K_3 \cdot Id_3)$$

$$\text{with } Id_1 > \frac{K_2}{K_1} \cdot Id_2 \qquad (4)$$

By observing equation 4, it may be easily recognized the fact that the gain of the amplifier is linearly controlled by $I_1$ and $I_2$, while by modifying the current $I_3$, it is possible to translate the gain characteristic.

According to the highly preferred embodiment shown in Figure 2, additional transistors M6 and M7 respectfully connected in parallel to the diode-connected load transistors M3, are used to subtrac a certain constant amount for the total current that would be flowing through the diode-connected load transistors M3. In this way, the current that actually flows through the diode-connected load transistors M3 may be fixed for setting the gm of the M3 transistors and therefore to translate the gain characteristic.

By substituting $I_3 = I_1 + I_2$ in equation 4, the following equation is obtained

$$\left(\frac{v_{out}}{v_{in}}\right)_{dB} = 20 \cdot \log\left(\sqrt{I_3 - I_2} - \sqrt{\frac{K_2}{K_1} \cdot Id_2}\right) - 10 \cdot \log\left(\frac{K_1}{K_3 \cdot Id_3}\right)$$

$$\text{with } I_3 > \left(\frac{K_2}{K_1} + 1\right) \cdot Id_2 \qquad (5)$$

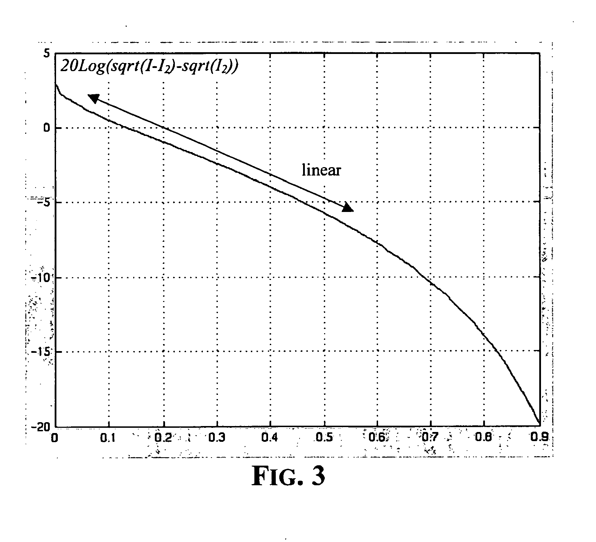

The expression 5 may be plotted as shown in Figure 3 in order to show the linear variation range of the dB gain figure.

The amplifier provides for an output signal of fixed amplitude while the input signal varies its amplitude.

When the gain is relatively high, the current in the first input differential pair of transistors M1 is much larger than the current in the second input differential pair of transistors M2. Under these conditions, linearity of the first differential input pair of transistors M1 is very good because its overdrive is relatively high, while the linearity of the other differential input pair of transistors M2 is relatively poor. However, this is not a problem because the contribution of the second differential pair M2 to the output current is proportionally very small and even its distortion has a negligible impact on the output current.

The gain is reduced by reducing the current in the first differential input pair M1 and complementarily increasing the current in the second input differential pair M2.

By reducing the current in the first differential input pair M1 while the input signal swing is increasing is detrimental to its linearity but at the same time, the linearity of the other differential input pair M2 is improving and in addition, the third harmonic of M2 is subtracted from the third harmonic of M1 thus enhancing the overall linearity of the amplifier, as may be inferred by the following expression:

$$i_{tot} = i_{1|H1} + i_{1|H3} - \left( i_{2|H1} + i_{2|H3} \right) \qquad (6)$$

where $i_1|H1$ indicates the first harmonic of the respective current signal $i_1$.

In conclusion, the novel amplifier of this invention has a markedly improved linearity in comparison with the known amplifier circuit of Figure 1.

Although the variable gain logarithmic linear amplifier with improved linearity characteristic of this invention may have innumerable applications, a particularly important application in which the amplifier of this invention is particularly useful is in data acquisition channels from a mass storage drive, such as a hard disk.

## Claims

1. A logarithmic linear variable gain CMOS amplifier comprising a first differential input pair of transistors (M1) with diode-connected load transistors (M3), whereby the first transistor of the differential input pair of transistors is connected in series with the first diode-connected load transistor and the second transistor of the differential input pair of transistors is connected in series with the second diode-connected load transistor, a second differential pair of transistors (M2) sharing the same diode-connected load transistors (M3), whereby the first transistor of the second differential pair of transistors is connected in series with the first diode-connected load transistor and the second transistor of the second /U differential pair of transistors is connected in series with the second diode connected load transistor, the control terminal of the first transistor of the differential input pair being shorted to the control terminal of the second transistor of the second differential pair and the control terminal of the second transistor of the differential input pair being shorted to the control terminal of the first transistor of the second differential pair, a pair of current mirrors (M4; M5) for injecting respective bias currents in the common source nodes of said input pair of transistors and said second differential pair of transistors, the input currents of said pair of current mirrors being provided by a digital-to-analog converter (DAC), said bias currents injected in the two differential pairs of transistors (M1; M2) are such that their sum is maintained constant, **characterized in that** said current mirrors (M4; M5) bias said two pairs of transistors (M1, M2) in a functioning region in which the transconductance gain of said pairs of transistors (M1, M2) is proportional to the square root of the bias current flowing therethrough, and said diode-connected load transistors (M3) arc biased in a functioning region in which their transconductance gain is proportional to the square root of the bias current flowing therethrough.

2. The variable gain amplifier according to claim 1, **characterized by** the fact that it further includes transistor means (M6; M7) connected in parallel to each of said diode-connected load transitors (M3) for subtracting a constant amount of current from said sum current that would otherwise be flowing through the diode-connected load transistors.

3. The variable gain amplifier according to claim 1, **characterized in that** said bias currents output by a linear digital-to-analog converter have values (A + x) and (B - x), respectively, A and B being programmed constant bias current values and x being a variable factor.

4. The variable gain amplifier according to anyone of the preceding claims, **characterized in that** the current in the diode-connected load transistors (M3) is varied for translating the gain characteristics of the amplifier.

5. The variable gain amplifier according to claim 2, **characterized in that** said transistor means (M6; M7) connected in parallel to each of said diode-connected load transitors are of opposite type of conductivity of said diode-connected load transistors (M3).

**Patentansprüche**

1. Logarithmischer linearer CMOS-Verstärker mit veränderlicher Verstärkung, der aufweist: ein erstes Differentialtransistoreingangspaar (M1) mit als Diode geschalteten Lasttransistoren (M3), wodurch der erste Transistor des Differentialtransistoreingangspaars mit dem ersten als Diode geschalteten Lasttransistor in Reihe geschaltet ist und der zweite Transistor des Differentialtransistoreingangspaars mit dem zweiten als Diode geschalteten Lasttransistor in Reihe geschaltet ist, wobei ein zweites Differentialtransistorpaar (M2) dieselben als Diode geschalteten Lasttransistoren (M3) gemeinsam nutzt, wodurch der erste Transistor des zweiten Differentialtransistorpaars mit dem ersten als Diode geschalteten Lasttransistor in Reihe geschaltet ist und der zweite Transistor des zweiten Differentialtransistorpaars mit dem zweiten als Diode geschalteten Lasttransistor in Reihe geschaltet ist, wobei der Steueranschluß des ersten Transistors des Differentialeingangspaars mit dem Steueranschluß des zweiten Transistors des zweiten Differentialpaars kurzgeschlossen ist und der Steueranschluß des zweiten Transistors des Differentialeingangspaars mit dem Steueranschluß des ersten Transistors des zweiten Differentialpaars kurzgeschlossen ist, und ein Stromspiegelpaar (M4; M5) zum Injizieren jeweiliger Vorströme in die gemeinsamen Sourceknoten des Transistoreingangspaars und des zweiten Differentialtransistorpaars, wobei die Eingangsströme des Stromspiegelpaars durch einen Digital-Analog-Wandler (DAC) bereitgestellt werden, wobei die in die beiden Differentialtransistorpaare (M1; M2) injizierten Vorströme so gestaltet sind, daß ihre Summe konstant gehalten wird, **dadurch gekennzeichnet, daß** die Stromspiegel (M4; M5) die beiden Transistorpaare (M1, M2) in einem Funktionsbereich vorspannen, in dem die Transkonduktanzverstärkung der Transistorpaare (M1, M2) proportional zur Quadratwurzel des dort hindurch fließenden Vorstroms ist, und die als Diode geschalteten Lasttransistoren (M3) in einem Funktionsbereich vorgespannt sind, in dem ihre Transkonduktanzverstärkung proportional zur Quadratwurzel des dort hindurch fließenden Vorstroms ist.

2. Verstärker mit veränderlicher Verstärkung nach Anspruch 1, **gekennzeichnet durch** die Tatsache, daß er ferner Transistormittel (M6; M7) aufweist, die parallel zu jedem der als Diode geschalteten Lasttransistoren (M3) geschaltet sind, um einen konstanten Strombetrag von dem Summenstrom zu subtrahieren, der andernfalls **durch** die als Diode geschalteten Lasttransistoren fließen würde.

3. Verstärker mit veränderlicher Verstärkung nach Anspruch 1, **dadurch gekennzeichnet, daß** die durch einen linearen Digital-Analog-Wandler abgegebenen Vorströme Werte (A + x) bzw. (B - x) aufweisen, wobei A und B programmierte konstante Vorstromwerte sind und x ein variabler Faktor ist.

4. Verstärker mit veränderlicher Verstärkung nach einem der vorhergehenden Ansprüche, **dadurch gekennzeichnet, daß** der Strom in den als Diode geschalteten Lasttransistoren (M3) zum Verschieben der Verstärkungseigenschaften des Verstärkers verändert wird.

5. Verstärker mit veränderlicher Verstärkung nach Anspruch 2, **dadurch gekennzeichnet, daß** die zu jedem der als Diode geschalteten Lasttransistoren parallel geschalteten Transistormittel (M6; M7) einen zu den als Diode geschalteten Lasttransistoren (M3) entgegengesetzten Leitfähigkeitstyp aufweisen.

**Revendications**

1. Amplificateur CMOS logarithmique linéaire à gain variable comprenant une première paire d'entrée différentielle de transistors (M1) munie de transistors de charge connectés en diode (M3), d'où il résulte que le premier transistor de la paire d'entrée différentielle de transistors est connecté en série avec le premier transistor de charge connecté en diode et le deuxième transistor de la paire d'entrée différentielle de transistors est connecté en série avec le deuxième transistor de charge connecté en diode, une deuxième paire différentielle de transistors (M2) partageant les mêmes transistors de charge connectés en diode (M3), d'où il résulte que le premier transistor de la deuxième paire différentielle de transistors est connecté en série avec le premier transistor de charge connecté en diode et le deuxième transistor de la deuxième paire différentielle de transistors est connecté en série avec le deuxième transistor de charge connecté en diode, la borne de commande du premier transistor de la paire d'entrée différentielle étant connectée à la borne de commande du deuxième transistor de la deuxième paire différentielle et la borne de commande du deuxième transistor de la paire d'entrée différentielle étant connectée à la borne de commande du premier transistor de la deuxième paire différentielle, une paire de miroirs de courant (M4 ; M5) pour injecter des courants de polarisation respectifs dans les noeuds de source commun de la paire d'entrée de transistors et de la deuxième paire différentielle de transistors, les courants d'entrée de la paire de miroirs de courant étant fournis par un convertisseur numérique-analogique (DAC), lesdits courants de polarisation injectés dans les deux paires différentielles de transistors (M1 ; M2) sont tels que leur somme est maintenue constante, **caractérisé en ce que** les miroirs de courant (M4 ; M5) polarisent les deux paires de transistors (M1, M2) dans une région de fonctionnement où le gain de transconductance desdites paires de transistors (M1, M2) est proportionnel à la racine carrée du courant de polarisation passant dedans, et les transistors de charge connectés en diode (M3) sont polarisés dans une région de fonctionnement où leur gain de transconductance est proportionnel à la racine carrée du courant de polarisation passant dedans.

2. Amplificateur à gain variable selon la revendication 1, **caractérisé en ce qu'**il comprend en outre des moyens de transistors (M6 ; M7) connectés en parallèle avec chacun des transistors de charge connectés en diode (M3) pour soustraire une quantité constante de courant du courant de somme qui autrement circulerait dans les transistors de charge connectés en diode.

3. Amplificateur à gain variable selon la revendication 1, **caractérisé en ce que** les courants de polarisation fournis par un convertisseur numérique-analogique linéaire ont des valeurs (A + x) et (B - x), respectivement, A et B étant des valeurs de courant de polarisation constantes programmées et x étant un facteur variable.

4. Amplificateur à gain variable selon l'une quelconque des revendications précédentes, **caractérisé en ce qu'**on fait varier le courant dans les transistors de charge connectés en diode (M3) pour décaler les caractéristiques de gain de l'amplificateur.

5. Amplificateur à gain variable selon la revendication 2, **caractérisé en ce que** les moyens de transistors (M6 ; M7) connectés en parallèle avec chacun des transistors de charge connectés en diode sont du type de conductivité opposé par rapport aux transistors de charge connectés en diode (M3).

OUTM ○

OUTP

INP ○

INM

DAC

$I+x$

$I-x$

**FIG. 1**

M6    **M3**    M7

○ OUTP

○ OUTM

INM ○

INP ○    **M1**    **M2**

DAC

$A + x$

$B - x$

**M4**    **M5**

**FIG. 2**

**FIG. 3**

**REFERENCES CITED IN THE DESCRIPTION**

**Patent documents cited in the description**

- US 20020048109 A1
- EP 1024450 A
- US 6584486 B